# FASCICULE DE BREVET EUROPEEN

(11) **EP 0 750 375 B1**
(45) Date de publication et mention de la délivrance du brevet: **03.03.1999**
(21) Numéro de dépôt: 96401320.5
(22) Date de dépôt: 18.06.1996
(51) Int. Cl.: H01S 3/19, H01L 21/308

(54) **Procédé pour former un plateau et une couverture sur ce plateau notamment sur un substrat semiconducteur**
Verfahren zum Herstellen einer Mesastruktur mit einer daraufliegenden Deckschicht insbesondere auf einem Halbleitersubstrat
Method of manufacturing a mesa with a cover layer on the mesa particularly on a semiconductor substrate

(30) Priorité: 22.06.1995 FR 9507496
(43) Date de publication de la demande: 27.12.1996
(73) Titulaire: ALCATEL, 75008 Paris (FR)
(72) Inventeur: Bodere, Alain, 91680 Bruyeres le Chatel (FR); Gaumont-Goarin, Elisabeth, 78460 Chevreuse (FR)
(74) Mandataire: Fournier, Michel Robert Marie

(56) Documents cités:
- EP-A- 0 542 479
- US-A- 4 857 477
- JAPANESE JOURNAL OF APPLIED PHYSICS, vol. 25, no. 9, Septembre 1986, TOKYO JP, pages 1443-1444, XP002014514 T. SANADA ET AL: "An Improved technique for fabricating high quantum efficiency ridge waveguide AlGaAs/GaAs quantum well lasers"
- PATENT ABSTRACTS OF JAPAN vol. 011, no. 187 (E-516), 16 Juin 1987 & JP-A-62 015876 (MATSUSHITA ELECTRIC IND CO LTD), 24 Janvier 1987,

## Description

La présente invention concerne un procédé pour former un plateau et une couverture sur ce plateau. Elle trouve notamment application lors de la fabrication d'un composant semiconducteur, notamment d'un composant optoélectronique, lorsque le plateau à couvrir est formé en saillie sur un substrat de ce composant et lorsque ladite couverture doit constituer une électrode sur ce plateau.

Les caractéristiques du préambule de la revendication 1 sont divulguées dans le document de Sanada, Kuno et Wada publié dans Japanese Journal of Applied Physics 25(9), p. 1443-1444 (1986).

Dans un procédé connu la couverture est d'abord formée par gravure d'une couche de couverture à travers un masque puis le plateau est formé par une gravure du matériau du substrat de part et d'autre de la couverture. Mais le moyen de gravure du substrat utilisé dans ce procédé est de nature à attaquer aussi la couverture. Cette dernière doit donc être préalablement protégée contre ce moyen. C'est pourquoi le masque utilisé pour former la couverture est choisi pour résister non seulement au moyen de gravure de couverture, mais aussi au moyen de gravure de substrat de sorte que, lors de la formation du plateau, ce masque constitue la protection souhaitée pour la couverture.

Dans le cadre de la présente invention, il a été trouvé que les composants fabriqués selon ce procédé connu présentaient des défauts se traduisant par des performances imparfaites et partiellement aléatoires.

La présente invention a notamment pour but de permettre d'améliorer et/ou de garantir les performances de tels composants.

Dans ce but elle a pour objet un procédé pour former un plateau et une couverture sur ce plateau notamment sur un substrat semiconducteur, ce procédé comportant les étapes de :
- réalisation d'un substrat présentant une face exposée par exemple horizontale,
- définition d'un moyen de gravure de substrat apte à attaquer ce substrat,
- dépôt sur ladite face exposée d'une couche de couverture sensible au moyen de gravure de substrat,
- définition d'un moyen de gravure de couverture apte à attaquer cette couche de couverture,
- formation d'un masque résistant à ces moyens de gravure de substrat et de couverture et recouvrant limitativement une zone de couverture sur cette couche de couverture,
- application du moyen de gravure de couverture à travers ce masque pour laisser la couche de couverture subsister sous la forme d'une couverture présentant d'une part une surface dans la zone de couverture, d'autre part un flanc formant saillie sur ladite face exposée dans une zone de flanc au bord de la zone de couverture, cette couverture étant éliminée dans une zone latérale s'étendant au-delà de cette zone de flanc,
- et application du moyen de gravure de substrat pour creuser ledit substrat dans ladite zone latérale de manière qu'une partie protégée dudit substrat constitue ledit plateau sous ladite couverture,
ce procédé étant caractérisé par le fait que, entre l'application du moyen de gravure de couverture et celle du moyen de gravure de substrat, il comporte en outre les étapes de :
- formation d'un revêtement constituant un revêtement supérieur, un revêtement de flanc et un revêtement de substrat occupant respectivement la zone de couverture, la zone de flanc et la zone latérale et présentant des surfaces respectives,
- et application d'un moyen de gravure de revêtement ayant une direction d'attaque sélective formant un angle plus petit avec la surface du revêtement de flanc qu'avec les surfaces du revêtement supérieur et du revêtement de substrat, cette application étant arrêtée alors que ce moyen de gravure a éliminé complètement le revêtement supérieur et le revêtement de substrat mais non le revêtement de flanc.
Dans le cadre de cette invention une cause a en effet été trouvée pour certains desdits défauts des composants fabriqués selon le procédé connu. Cette cause est que, lors de l'étape de gravure du substrat, le moyen de gravure utilisé attaquait légèrement le flanc de la couverture précédemment formée. Comme conséquence de cette attaque parasite certains des atomes du matériau de la couverture venaient se redéposer sur le substrat au voisinage de la couverture et perturbaient alors la poursuite du processus de gravure du substrat.

De manière plus générale le procédé selon l'invention trouve application lorsque le matériau de couverture et le moyen de gravure de substrat présentent des avantages spécifiques et lorsque ce matériau et ce moyen présentent en même temps une incompatibilité telle que tout contact doit être évité entre eux, par exemple parce que la couverture serait dommageablement attaquée à partir de son flanc, ou parce que les produits de cette attaque seraient gênants, ou parce que ce contact permettrait le passage d'un courant électrique parasite etc...Elle permet alors de bénéficier de ces avantages malgré l'existence de cette incompatibilité.

A l'aide des figures schématiques ci-jointes, on va décrire plus particulièrement ci-après, à titre d'exemple non limitatif, comment la présente invention peut être mise en oeuvre. Lorsqu'un même élément est représenté sur plusieurs figures il y est désigné par le même signe de référence.

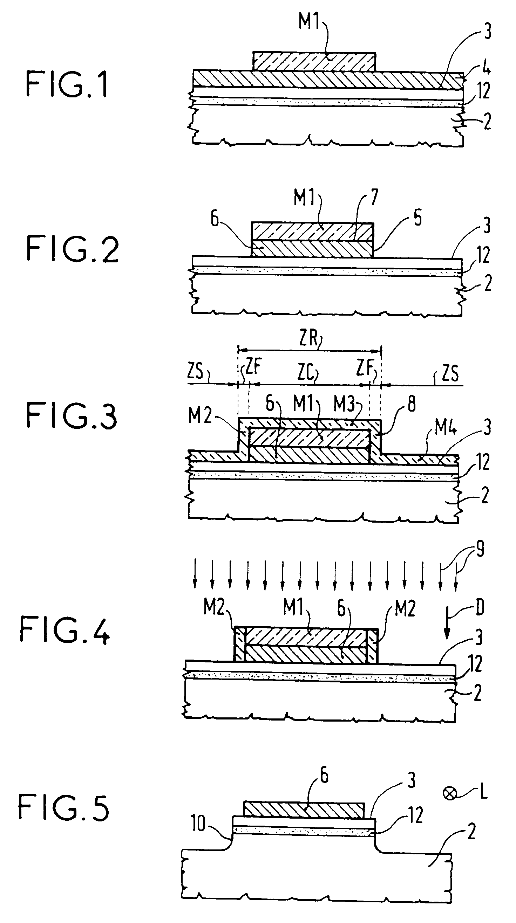

Les figures 1 à 5 représentent des vues en coupe d'un composant optoélectronique fabriqué par le procédé de cette invention, à des étapes successives de ce procédé.

Conformément à la figure 1 et de manière connue, on a réalisé un substrat 2 présentant une face exposée 3, par exemple horizontale. On a défini un moyen de gravure de substrat apte à attaquer ce substrat. On a déposé sur cette face exposée une couche de couverture 4 sensible au moyen de gravure de substrat. On a défini un moyen de gravure de couverture apte à attaquer cette couche de couverture, et on a formé un masque M1 résistant à ces moyens de gravure de substrat et de couverture et recouvrant limitativement une zone de couverture ZC sur cette couche de couverture.

Conformément à la figure 2 on a appliqué le moyen de gravure de couverture à travers ce masque pour laisser la couche de couverture subsister sous la forme d'une couverture 6 présentant d'une part une surface 7 dans la zone de couverture, d'autre part un flanc 5 formant saillie sur la face exposée 3 dans une zone de flanc ZF au bord de la zone de couverture ZC, cette couverture étant éliminée dans une zone latérale ZS s'étendant au-delà de cette zone de flanc.

Conformément à la figure 5 on a appliqué le moyen de gravure de substrat pour creuser le substrat 2 dans la zone latérale ZS de manière que la partie du substrat qui est située sous la couverture 6 et qui est protégée par cette dernière constitue un plateau 10.

Selon la présente invention, entre l'application du moyen de gravure de couverture et celle du moyen de gravure de substrat, et conformément à la figure 3, on a formé un revêtement 8. Diverses parties de ce revêtement constituent un revêtement supérieur M3, un revêtement de flanc M2 et un revêtement de substrat M4 occupant respectivement la zone de couverture ZC, la zone de flanc ZF et la zone latérale ZS et présentant des surfaces respectives. Puis, conformément à la figure 4, on a appliqué un moyen de gravure de revêtement ayant une direction d'attaque sélective D formant un angle plus petit avec la surface du revêtement de flanc qu'avec les surfaces du revêtement supérieur et du revêtement de substrat M4. Cette application a été arrêtée alors que ce moyen de gravure a éliminé complètement les revêtements de plateau et de substrat mais non le revêtement de flanc.

De préférence le revêtement 8 a été formé par un dépôt sensiblement uniforme et isotrope d'un matériau de revêtement résistant au moyen de gravure de substrat, et les moyens de gravure de couverture et de revêtement ont chacun une direction d'attaque sélective D, cette direction leur étant commune et étant perpendiculaire au plan de la face exposée 3.

De préférence encore le masque M1 et le revêtement de flanc M2 sont éliminés après l'application du moyen de gravure de substrat.

Dans un mode de mise en oeuvre, le substrat 2 est semiconducteur et comporte une couche active 12 optiquement amplificatrice et guidante. La zone de couverture ZC et la zone de flanc ZF constituent ensemble une zone de ruban ZR s'étendant en longueur selon une direction longitudinale L perpendiculaire au plan des figures et en largeur entre deux dites zones latérales ZS.

L'application du moyen de gravure de substrat élimine cette couche active dans ces zones latérales, de manière à la laisser subsister limitativement dans la zone de ruban sous la forme d'un ruban laser 10 constituant ledit plateau.

La couche de couverture 4 est métallique pour que la converture 6 constitue une électrode supérieure pour ce ruban laser. Elle est typiquement constituée à base d'or et de titane. Dans le cadre de la présente invention il a été trouvé qu'en l'absence du revêtement de flanc M2, un moyen de gravure de substrat présentant par ailleurs certains avantages attaquait les flancs de l'électrode et que certains des atomes ou ions métalliques arrachés de ces flancs venaient se déposer sur le substrat et perturber la suite du processus de gravure.

Lorsqu'il s'agit par exemple de réaliser un composant optoélectronique comportant un guide optique, notamment un amplificateur optique, une électrode inférieure est formée au contact d'une face inférieure non représentée du substrat. De préférence dans ce cas le masque M1 et le revêtement 8 sont constitués d'un diélectrique tel que la silice Si02 ou le nitrure de silicium Si3N4, le moyen de gravure de couverture est un usinage par faisceau ionique (Ion Beam Etching), le dépôt de revêtement est un dépôt chimique en phase vapeur assisté par plasma (Plasma Enhanced Chemical Vapor Deposition), le moyen de gravure de revêtement est un usinage par des ions réactifs qui sont créés dans un plasma et qui sont accélérés vers le substrat semiconducteur (Reactive Ions Beam Etching), et le moyen de 5 gravure de subtrat est un usinage par faisceau d'ions réactifs accélérés (Reactive Ions Beam Etching) ou un usinage par ions réactifs accélérés.

Ce moyen de gravure de substrat présente l'avantage d'une grande uniformité et d'une bonne reproductibilité de l'attaque.

## Revendications

1. Procédé pour former un plateau et une couverture sur ce plateau notamment sur un substrat semiconducteur, ce procédé comportant les étapes de :
- réalisation d'un substrat (2) présentant une face exposée (3) par exemple horizontale,
- définition d'un moyen de gravure de substrat apte à attaquer ce substrat,
- dépôt sur ladite face exposée d'une couche de couverture (4) sensible au moyen de gravure de substrat,
- définition d'un moyen de gravure de couverture apte à attaquer cette couche de couverture,
- formation d'un masque (M1) résistant à ces moyens de gravure de substrat et de couverture et recouvrant limitativement une zone de couverture (ZC) sur cette couche de couverture,
- application du moyen de gravure de couverture à travers ce masque pour laisser la couche de couverture subsister sous la forme d'une couverture (6) présentant d'une part une surface (7) dans la zone de couverture, d'autre part un flanc (5) formant saillie sur ladite face exposée dans une zone de flanc (ZF) au bord de la zone de couverture, cette couverture étant éliminée dans une zone latérale (ZS) s'étendant au-delà de cette zone de flanc,
- et application du moyen de gravure de substrat pour creuser ledit substrat dans ladite zone latérale de manière qu'une partie protégée dudit substrat (2) constitue ledit plateau (10) sous ladite couverture,
ce procédé étant caractérisé par le fait que, entre l'application du moyen de gravure de couverture et celle du moyen de gravure de substrat, il comporte en outre les étapes de :
- formation d'un revêtement (8) constituant un revêtement supérieur (M3), un revêtement de flanc (M2) et un revêtement de substrat (M4) occupant respectivement la zone de couverture (ZC), la zone de flanc (ZF) et la zone latérale (ZS) et présentant des surfaces respectives,
- et application d'un moyen de gravure de revêtement ayant une direction d'attaque sélective (D) formant un angle plus petit avec la surface du revêtement de flanc qu'avec les surfaces du revêtement supérieur et du revêtement de substrat (M4), cette application étant arrêtée alors que ce moyen de gravure a éliminé complètement le revêtement supérieur et le revêtement de substrat mais non le revêtement de flanc.

2. Procédé selon la revendication 1, ladite étape de formation d'un revêtement (8) étant réalisée par un dépôt sensiblement uniforme et isotrope d'un matériau de revêtement résistant au moyen de gravure de substrat, lesdits moyens de gravure de couverture et de revêtement ayant chacun une direction d'attaque sélective (D), cette direction leur étant commune et étant perpendiculaire au plan de ladite face exposée (3).

3. Procédé selon la revendication 1, ledit masque (M1) et ledit revêtement de flanc (M2) étant éliminés après l'application du moyen de gravure de substrat.

4. Procédé selon la revendication 1, ledit substrat (Z) étant semiconducteur et comportant une couche active (12) optiquement amplificatrice et guidante,
ladite zone de couverture (ZC) et ladite zone de flanc (ZF) constituant ensemble une zone de ruban (ZR) s'étendant selon une direction longitudinale (L) entre deux dites zones latérales (ZS),
ladite application du moyen de gravure de substrat éliminant cette couche active dans ces zones latérales, de manière à la laisser subsister limitativement dans ladite zone de ruban sous la forme d'un ruban laser (10) constituant ledit plateau, ladite couche de couverture (4) étant métallique pour que ladite converture (6) constitue une électrode supérieure pour ce ruban laser.

5. Procédé selon la revendication 4, ledit masque (M1) et ledit revêtement (8) étant constitués d'un diélectrique tel que la silice Si02 ou le nitrure de silicium Si3N4,
ledit moyen de gravure de couverture étant un usinage ionique, ledit dépôt de revêtement étant un dépôt chimique en phase vapeur assisté par plasma, ledit moyen de gravure de revêtement étant un usinage par ions réactifs accélérés, ledit moyen de gravure de substrat étant un usinage par un faisceau d'ions réactifs.

## Patentansprüche

1. Verfahren zum Bilden eines Plateaus und einer Abdeckung auf diesem Plateau, insbesondere auf einem Halbleitersubstrat, wobei das Verfahren die folgenden Schritte umfasst:
Herstellen eines Substrates (2), das eine freiliegende, z.B. horizontale Seite (3) aufweist, Definieren eines Substratätzmittels, das dazu geeignet ist, dieses Substrat anzugreifen,
Abscheiden einer Abdeckungsschicht (4), die für das Substratätzmittel empfindlich ist, auf der freiliegenden Seite,
Definieren eines Abdeckungsatzmittels, das dazu geeignet ist, diese Abdeckungsschicht anzugreifen, Bilden einer Maske (M1), die gegen Substrat- und Abdeckungsätzmittel beständig ist und begrenzcnd eine Abdeckungszone (ZC) auf dieser Abdeckungsschicht überdeckt,
Anwenden des Abdeckungsätzmittels durch diese Maske hindurch, um die Abdeckungsschicht in Form einer Abdeckung (6) fortbestehen zu lassen, die zum einen eine Oberfläche (7) in der Abdeckungszone und zum anderen eine Flanke (5) aufweist, die an der besagten freiliegenden Seite in einer Flankenzone (ZF) am Rande der Abdeckungszone vorsteht, wobei diese Abdeckung in einer seitlichen zone (ZS) entfernt wird, die sich über diese Flankenzone hinaus erstreckt.
Anwenden des Substratätzmittels, um das Substrat in der seitlichen Zone so zu vertiefen, dass ein geschützter Teil des Substrates (2) das Plateau (10) unter der Abdeckung bildet,
**dadurch gekennzeichnet,** dass es zwischen dem Anwenden des Abdeckungsätzmittels und dem des Substratätzmittels außerdem die Schritte umfasst:
Erzeugen eines Überzugs (8), der einen oberen Überzug (M3), einen Flankenüberzug (M2) und einen Substratüberzug (M4) bildet, der jeweils die Abdeckungszone (ZC), die Flankenzone (ZF) und die seitliche Zone (ZS) bedeckt und entsprechende Oberflächen aufweist,
Anwenden eines Überzugsätzmittels, das eine selektive Angriffsrichtung (D) hat, die einen kleineren Winkel mit der Oberfläche des Flankenüberzugs als mit den Oberflächen des oberen Überzugs und des Substratüberzugs (M4) bildet, wobei dieses Anwenden angehalten wird, wenn dieses Ätzmittel vollständig den oberen Überzug und den Substratüberzug, aber nicht den Flankenüberzug entfernt hat.

2. Verfahren nach Anspruch 1, bei dem der Schritt des Bilden eines Überzugs (8) durch ein im wesentlichen gleichförmiges isotropes Abscheiden eines bezüglich des Substratätzmittels widerstandsfähigen Überzugsmaterials verwirklicht wird, wobei Abdeckungs- und Überzugsätzmittel jeweils eine selektive Angriffsrichtung (D) haben, wobei diese Richtung ihnen gemeinsam ist und senkrecht zur Ebene der freiliegenden Fläche (3) ist.

3. Verfahren nach Anspruch 1, bei dem die Maske (M1) und der Flankenüberzug (M2) nach dem Anwenden des Substratätzmittels entfernt werden.

4. Verfahren nach Anspruch 1, bei dem das Substrat (Z) ein Halbleiter ist und eine optisch verstärkende und leitende aktive Schicht (12) umfasst, wobei die Abdeckungszone (ZC) und die Flankenzone (ZF) gemeinsam eine Bandzone (ZR) bilden, die sich in einer Längsrichtung (L) zwischen zwei seitlichen Zonen (ZS) erstreckt,
wobei das Anwenden des Substratätzmittels die aktive Abdeckung in diesen seitlichen Zonen so entfernt, dass sie in der Bandzone in Form eines Laserbands (10), das das Plateau bildet, begrenzend bestehen bleibt, wobei die Abdeckungsschicht (4) metallisch ist, damit die Abdeckung (6) eine obere Elektrode für das Laserband darstellt.

5. Verfahren nach Anspruch 4, bei dem die Maske (M1) und der Überzug (8) aus einem Dielektrikum, z.B. Siliziumdioxid SiO₂ oder Siliziumnitrid Si₃N₄ bestehen, das Abdeckungsätzmittel eine Ionenbearbeitung ist, das Überzugabscheiden ein plasmaunterstütztes chemisches Abscheiden in der Dampfphase ist, das Überzugsätzmittel eine Bearbeitung mit beschleunigten reaktiven Ionen ist und das Substratätzmittel eine Bearbeitung durch einen Strahl reaktiver Ionen ist.

## Claims

1. A method of forming a plateau and a cover on said plateau, in particular on a semiconductor substrate, the method including the following steps:
making a substrate (2) having an optionally horizontal exposed face (3);
defining substrate-etching means that are suitable for etching the substrate;
depositing a cover layer (4) on said exposed face, which cover layer is sensitive to the substrate-etching means;
defining cover-etching means that are suitable for etching the cover layer;
forming a mask (M1) that withstands the substrate-etching means and the cover-etching means, and that covers a limited cover zone (ZC) of the cover layer;
applying the cover-etching means via the mask so that the cover layer remains in the form of a cover (6) having a surface (7) in the cover zone and a flank (5) projecting relative to said exposed face in a flank zone (ZF) at the edge of the cover zone, the cover being removed in a side zone (ZS) extending beyond the flank zone; and
applying the substrate-etching means so as to etch said substrate in said side zone so that a protected portion of said substrate (2) constitutes said plateau (10) under said cover;
said method being characterized by the fact that, between application of the cover-etching means and application of the substrate-etching means, it further includes the following steps:
forming a coating (8) constituting a top coating (M3), a flank coating (M2), and a substrate coating (M4) respectively occupying the cover zone (ZC), the flank zone (ZF), and the side zone (ZS) and having respective surfaces; and
applying coating-etching means having a selective etching direction (D) forming a smaller angle with the surface of the flank coating than with the surfaces of the top coating and of the substrate coating (M4), this application being stopped once the etching means have completely removed the top coating and the substrate coating but not the flank coating.

2. A method according to claim 1, said step of forming a coating (8) being performed by depositing substantially uniformly and isotropically a coating material that is resistant to the substrate-etching means, each of said cover-etching means and said coating-etching means having a selective etching direction (D), the direction being common to them and perpendicular to the plane of said exposed face (3).

3. A method according to claim 1, said mask (M1) and said flank coating (M2) being removed after applying the substrate-etching means.

4. A method according to claim 1, said substrate (Z) being a semiconductor substrate and including an optically amplifying and guiding active layer (12);
said cover zone (ZC) and said flank zone (ZF) together constituting a ridge zone (ZR) extending in a longitudinal direction (L) between two of said side zones (ZS);
said application of the substrate-etching means removing the active layer in the side zones, so that it remains in limited manner in said ridge zone in the form of a laser ridge (10) constituting said plateau, said cover layer (4) being metallic so that said cover (6) constitutes a top electrode for the laser ridge.

5. A method according to claim 4, said mask (M1) and said coating (8) being constituted by a dielectric such as silica SiO₂ or silicon nitride Si₃N₄;
said cover-etching means being constituted by ion etching, said coating being deposited by plasma enhanced chemical vapor deposition, said coating-etching means being constituted by reactive ion etching, and said substrate-etching means being constituted by reactive ion beam etching.
